(19) Europäisches Patentamt
European Patent Office
Office européen des brevets

(11) **EP 3 829 064 B1**

(12) **EUROPÄISCHE PATENTSCHRIFT**

(45) Veröffentlichungstag und Bekanntmachung des Hinweises auf die Patenterteilung:
**07.09.2022 Patentblatt 2022/36**

(21) Anmeldenummer: **19212336.2**

(22) Anmeldetag: **28.11.2019**

(51) Internationale Patentklassifikation (IPC):
**H03K 17/94** (2006.01)   **G06N 3/02** (2006.01)

(52) Gemeinsame Patentklassifikation (CPC):
**H03K 17/94; G06N 3/0454; G06N 7/005; G06N 20/20**

(54) **SENSOREN ZUM ERMITTELN EINES AUSGABEWERTS, VERFAHREN ZUM AUSWERTEN EINES SENSORSIGNALS UND VERFAHREN ZUM TRAINIEREN EINER AUSGABEEINHEIT ZUM AUSWERTEN EINES SENSORSIGNALS**

SENSOR FOR DETERMINING AN OUTPUT VALUE, METHOD FOR EVALUATING A SENSOR SIGNAL AND METHOD FOR TRAINING AN OUTPUT UNIT FOR EVALUATING A SENSOR SIGNAL

CAPTEURS DESTINÉS À DÉTERMINER UNE VALEUR DE SORTIE, PROCÉDÉ D'ÉVALUATION D'UN SIGNAL DE CAPTEUR ET PROCÉDÉ D'APPRENTISSAGE D'UNE UNITÉ DE SORTIE DESTINÉE À ÉVALUER UN SIGNAL DE CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**02.06.2021 Patentblatt 2021/22**

(73) Patentinhaber: **SICK AG**
**79183 Waldkirch (DE)**

(72) Erfinder:
• **PETER, Andreas**
**79312 Emmendingen (DE)**

• **THOSS, Sascha**
**79183 Waldkirch (DE)**
• **MACHUL, Olaf**
**79294 Sölden (DE)**

(74) Vertreter: **Manitz Finsterwald**
**Patent- und Rechtsanwaltspartnerschaft mbB**
**Martin-Greif-Strasse 1**
**80336 München (DE)**

(56) Entgegenhaltungen:
**WO-A1-2014/146623     DE-A1-102017 220 788**
**US-A- 5 898 304**

**EP 3 829 064 B1**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft Sensoren zum Ermitteln eines Ausgabewerts, Verfahren zum Auswerten eines Sensorsignals und Verfahren zum Trainieren einer Ausgabeeinheit zum Auswerten eines Sensorsignals.

Sensoren werden oft in rauer Umgebung eingesetzt. Beispielsweise können induktive Näherungssensoren als berührungslose Schalter eingesetzt werden. Ein wichtiges Qualitätsmerkmal ist dabei der maximal erreichbare Schaltabstand. Neben dem offensichtlichen Vorteil, dass ein Objekt schon in größeren Entfernungen detektiert werden kann, hat ein hoher Schaltabstand noch weitere Vorteile. Je höher der Schaltabstand des Sensors ist, desto größer kann der potentielle Abstand zum zu detektierenden Objekt sein. Dadurch verringert sich die Wahrscheinlichkeit von mechanischer Zerstörung. Ein weiterer Vorteil großer Schaltabstände ist die größere Einbautoleranz. Dadurch muss der Techniker bei der Montage des Sensors nicht so präzise arbeiten, was Zeit und Geld sparen kann sowie die Verfügbarkeit des Systems erhöhen kann.

Ein weiterer Vorteil ist das Miniaturisierungspotential. Wenn bei einem bestimmten Sensordurchmesser ein größerer Schaltabstand realisiert werden kann, besteht die Möglichkeit, eine Detektionsaufgabe ggf. mit einem kleineren Sensor zu lösen, was häufig konstruktive Vorteile hat.

Ein weiteres wichtiges Qualitätsmerkmal induktiver Näherungssensoren ist neben der Größe des Nennschaltabstandes Sn, welcher für Stahl definiert ist, auch die Größe des realen Schaltabstandes, der bei anderen Materialien erreicht wird. Diese Schaltabstände werden durch die sogenannten Reduktionsfaktoren charakterisiert. Auch hier gilt, dass ein großer Schaltabstand (bzw. ein großer Reduktionsfaktor) bevorzugt ist. Idealerweise hat der Sensor den gleichen hohen Schaltabstand für beliebige Metalle. Die Reduktionsfaktoren haben in diesem Fall den Maximalwert 1 und werden deshalb auch F1 (Faktor 1) - Sensoren genannt.

Die höchsten Schaltabstände werden aktuell zum Beispiel von Sensoren mit Kunststoffkappe erreicht, die bei einigen Bauformen den vierfachen Wert eines Standardnennschaltabstandes erreichen. Dabei handelt es sich um Sensoren, die nach dem klassischen Güteverfahren arbeiten, wie beispielsweise Sensoren aus der IME-Familie von SICK, beispielsweise IME08-04BPOZT0S. Der Nachteil dieser Sensoren besteht darin, dass sie kein F1-Verhalten besitzen. Da bei diesen Sensoren im Allgemeinen nur die Amplitude einer Sinusschwingung bei einer Frequenz als Information zur Verfügung steht, lässt sich dieser Nachteil auch nicht durch intelligente Algorithmen beheben.

Sensoren, die mit einem Pulsverfahren arbeiten (bei denen beispielsweise eine Spule mit einem Strompuls angeregt und die Pulsantwort, also die in der Spule induzierte Spannung als Spannungspuls, gemessen wird), bieten dagegen den Vorteil, dass in dem Puls mehr Informationen enthalten sind, da ein Puls als Gemisch aus Sinussignalen unterschiedlicher Frequenz, Amplitude und Phasenlage betrachtet werden kann. Entsprechend enthält auch die Pulsantwort mehr Informationen. Solche Sensoren können nahezu ein F1-Verhalten zumindest bei Stahl und Aluminium aufweisen, haben jedoch immer noch eine relativ starke Einbauabhängigkeit.

Eine weitere wichtige Eigenschaft, welche den Schaltabstand des Sensors beeinflusst, ist seine Empfindlichkeit gegenüber dem Einbau. Idealerweise ist ein Sensor völlig unempfindlich auf seine Einbautiefe und auf das Einbaumaterial und behält (im Fall von induktiven Näherungssensoren) immer seinen spezifizierten Schaltabstand.

Aus der WO 2014/146623 A1 ist bekannt, bei einem induktiven Wegmesssensor zur Messung des Abstandes, der räumlichen Orientierung, der Dicke, der Materialeigenschaften oder dergleichen eines Zielobjekts, welcher ein ein impulsförmiges Signal aussendendes Senderelement und ein Empfängerelement zur Erfassung einer durch das ausgesendete impulsförmige Signal in dem Zielobjekt hervorgerufenen Impulsantwort aufweist, vorzusehen, dass die erfasste Impulsantwort mittels eines künstlichen neuronalen Netzwerks unmittelbar ausgewertet wird.

US 5 898 304 A offenbart eine Sensoranordnung mit mindestens einer Messspule, mindestens einer Spannungsquelle für die Messspule und einer Auswerteeinheit mit Mitteln zum Erfassen, Verarbeiten und Auswerten von Messsignalen, mit der im wesentlichen materialunabhängige Abstands- und Dickenmessungen durchgeführt werden können, ohne dass dem Benutzer die physikalischmathematischen Zusammenhänge zwischen den Störgrößen und den Messgrößen bekannt sein müssen. Die Auswerteeinheit der Sensoranordnung umfasst zum Auswerten der Messsignale ein neuronales Netzwerk mit einer Eingangsschicht, mindestens einer verdeckten Schicht, einer Ausgangsschicht und Verknüpfungsgewichten für die einzelnen Schichten. Die Verknüpfungsgewichte sind in einer Lernphase durch Messungen an mehreren verschiedenen geeigneten Lernobjekten mit bekanntem Ist-Wert bestimmt und abgespeichert.

DE 10 2017 220788 A1 beschreibt ein Verfahren zum überwachten Trainieren eines Künstlichen-Intelligenz-Moduls, KI-Moduls, zum Ermitteln einer Geschwindigkeit eines Fahrzeugs basierend auf von dem Fahrzeug erfassten ersten Sensorsignalen, mit den Schritten: Erfassen von ersten Sensorsignalen wenigstens zwei unterschiedlicher Sensoren; Ermitteln einer Geschwindigkeit des Fahrzeugs anhand von Referenzsignalen von Referenzsensoren; überwachtes Trainieren des KI-Moduls basierend auf den erfassten ersten Sensorsignalen und der ermittelten Geschwindigkeit des Fahrzeugs.

Die Erfindung ist durch die angehängten Ansprüche definiert. Beispiele, die nicht unter einen der Ansprüche fallen, sind als Beispiele zum besseren Verständnis der Erfindung angegeben.

Es ist Aufgabe der Erfindung, einen robusten Sensor bereitzustellen. Insbesondere soll ein Induktivsensor bereitgestellt werden, der die oben genannten Eigenschaften (hoher Sn-Wert, F1-Verhalten und geringe Einbauabhängigkeit) in einem Gerät vereinigt oder bei zumindest einer der Eigenschaften besonders gut ist.

Die Lösung der Aufgabe erfolgt durch einen Sensor zum Ermitteln eines Ausgabewerts mit den Merkmalen des Anspruchs 1, ein Verfahren zum Auswerten eines Sensorsignals mit den Merkmalen des Anspruchs 10 und ein Verfahren zum Trainieren einer Auswerteeinheit zum Auswerten eines Sensorsignals (des Sensors mit den Merkmalen von einem der Ansprüche 1 bis 9) mit den Merkmalen des Anspruchs 11.

Ein erfindungsgemäßer Sensor zum Ermitteln eines Ausgabewerts umfasst:

- eine Erfassungseinheit, eingerichtet zum Erfassen eines Sensorsignals;
- eine Vorverarbeitungseinheit, eingerichtet zum Ermitteln eines Zwischensignals basierend auf dem Sensorsignal und einem vorgegebenen Referenzsignal; und
- eine gemäß einem Maschinenlernverfahren trainierte Auswerteeinheit, eingerichtet zum Ermitteln des Ausgabewerts basierend auf dem Zwischensignal.

In anderen Worten wird in einem erfindungsgemäßen Sensor der Ausgabewert nicht direkt basierend auf dem Sensorsignal, sondern basierend auf dem Zwischensignal unter Verwendung einer mit einem Maschinenlernverfahren trainierten Auswerteeinheit ermittelt. Beispielsweise kann zum Trainieren der Auswerteeinheit das unten beschriebene Verfahren (Verfahren zum Trainieren einer Auswerteeinheit zum Auswerten eines Sensorsignals) verwendet werden.

Es versteht sich, dass jedes Signal (beispielsweise das Sensorsignal, das Referenzsignal, das Zwischensignal) einen zeitlichen Verlauf hat.

Das Sensorsignal kann dabei das Signal sein, dass der Sensor liefert. Das Sensorsignal kann also der unmittelbare Gegenstand der Messung des Sensors sein. Beispielsweise kann das Sensorsignal eine Spannung bzw. ein Spannungsverlauf sein. Das Sensorsignal kann in einem fortschreitenden Zeitfenster betrachtet werden (beispielsweise ein Zeitintervall vorgegebener Länge, beispielsweise die letzten 50 ms), oder es können regelmäßig neue Zeitfenster bestimmt werden (z.B. in einem vorgegebenen zeitlichen Abstand, z.B. alle 500 ms). Alternativ kann beispielsweise im Fall eines induktiven Näherungssensors das Zeitfenster abgestimmt sein auf einen Strompuls, der in einer Spule des induktiven Näherungssensors eine Spannung induziert; das Zeitfenster kann dann so gewählt werden, dass es die komplette Pulsantwort enthält (also so lange dauern, bis der induzierte Spannungspuls komplett oder zu einem vorgegebenen Spannungswert abgeklungen ist) oder eine vorgegebene Zeit dauern.

Das vorgegebene Referenzsignal kann eine Länge haben, die der Länge des Sensorsignals entspricht (also beispielsweise der Länge des fortschreitenden Zeitfenster oder des Abstands des Beginns neuer Zeitfenster).

Der Ausgabewert kann die Messgröße sein, also der Wert, der als die Messung gilt und der für den Benutzer des Sensors relevant ist. Beispielsweise kann der Ausgabewert eine Zahl sein, die das Messergebnis des Sensors repräsentiert.

Durch die Verwendung des vorgegebenen Referenzsignals zur Ermittlung eines Zwischensignals und durch das Auswerten des Zwischensignals kann erreicht werden, dass sensorspezifische Unterschiede des Sensorsignals beim Einsatz von Machine-Learning-Verfahren zum Ermitteln des Ausgabewerts keine oder nur geringe Auswirkungen auf den Ausgabewert haben. Dadurch kann ein typspezifisches (also sensortypspezifisches) Training ausreichen und kein sensorindividuelles Training nötig sein. Es kann also das Machine-Learning-Verfahren basierend auf den Messwerten nur eines einzigen Sensors trainiert werden. Zudem kann das trainierte Machine-Learning-Verfahren dann für jeden individuellen Sensor des gleichen oder eines ähnlichen Typs eingesetzt werden. Sensorindividuelles Training ist ein aufwendiger und teurer Prozess, der praktisch nur im Labor und nicht in realen Massenprodukten durchführbar ist. Der erfindungsgemäße Sensor reduziert daher die Herstellungskosten, da nicht für jeden einzelnen Sensor, sondern nur für jeden Sensortyp (beispielsweise nur für einen Referenzsensor), ein Training notwendig ist.

In Weiterbildung der Erfindung ist für jeden Sensor ein eigener Referenzpuls als Referenzsignal aufgenommen und abgespeichert. Die Aufnahme dieses sensorspezifischen (in anderen Worten: sensorindividuellen) Referenzpulses wird bei der Herstellung für jeden Sensor individuell aufgenommen und abgespeichert. Dieser Vorgang kann beispielsweise bei der Endprüfung vorgenommen werden und ist nicht zeitaufwändig. Das Referenzsignal kann also ein Sensorsignal des Sensors selbst sein. Das Referenzsignal kann also ein sensorspezifisches (oder sensorindividuelles) Referenzsignal sein.

Das vorgegebene Referenzsignal kann (insbesondere beim Training, wie weiter unten beschrieben) ein Sensorsignal eines Referenzsensors aufweisen. Der Sensor und der Referenzsensor können baugleich oder vom gleichen Typ sein.

Die Vorverarbeitungseinheit kann zum Ermitteln mindestens eines Zwischensignals basierend auf dem Sensorsignal und mindestens einem vorgegebenen Referenzsignal, das aus einer Mehrzahl von Referenzsignalen ausgewählt wird, eingerichtet sein. Dabei kann die Mehrzahl von Referenzsignalen verschiedene Referenzsignale enthalten, die unter unterschiedlichen Bedingungen (z.B. für unterschiedliche Einbausituationen oder für unterschiedliche Targetmaterialien) ermittelt wurden. Die Vorverarbeitungseinheit kann dann ein Referenzsignal aus dieser Mehrzahl von Referenzsignalen wählen (beispielsweise kann an dem Sensor eine Auswahleinrichtung angebracht sein, beispielsweise ein Schalter oder eine Mehrzahl von Schaltern, beispielsweise ein DIP-Schalter (DIP für englisch: "dual in-line package"; deutsch: "zweireihiges Gehäuse"), über den der Benutzer die Einbausituation und/oder das gewünschte Targetmaterial einstellen kann). Alternativ kann die Vorverarbeitungseinheit den Ausgabewert für zwei oder mehr der Referenzsignale (beispielsweise für alle Referenzsignale) ermitteln, und dann aus der so erhaltenen Mehrzahl von Ausgabewerten einen geeigneten Ausgabewert ermitteln (beispielsweise über eine Minimumbildung oder eine andere geeignete (z.B. mathematische) Funktion).

Das vorgegebene Referenzsignal kann in einem Speicher gespeichert werden. Dieser Speicher kann direkt im Sensor enthalten sein. Alternativ kann der Speicher in einer Vorrichtung, die zur weiteren Verarbeitung des Ausgabewerts bereitgestellt wird, enthalten sein. Der Speicher kann ein Festwertspeicher oder ein flüchtiger Speicher sein. Der Speicher kann zur Produktionszeit des Sensors beschrieben werden.

Die Toleranzen des Sensors (wie beispielsweise Verstärkungsfaktoren oder Spulenposition) haben zwar einen Einfluss auf die Trainingsdaten und damit später auf die Klassifikation- und Regressionsergebnisse der Maschinenlernverfahren in der Inferenzphase (d. h. in der Phase des Einsatzes des trainierten Maschinenlernverfahrens), jedoch können diese Einflüsse durch die Verwendung eines vorgegebenen Referenzsignals und des Einsatzes der Auswerteeinheit basierend auf dem Zwischensignal reduziert werden.

Vorteilhafterweise ist die Erfassungseinheit eingerichtet zum Digitalisieren des Sensorsignals. Beispielsweise kann die Pulsantwort vollständig digitalisiert werden. Durch eine Digitalisierung des Sensorsignals kann eine digitale Signalverarbeitung zum Ermitteln des Ausgabewerts verwendet werden. Beispielsweise können Machine-Learning-Verfahren verwendet werden, um die Pulsantwort nach Vorverarbeitung auszuwerten, also um das Zwischensignal auszuwerten.

Gemäß einer vorteilhaften Ausgestaltung des Sensors kann die Vorverarbeitungseinheit ferner zum Vorverarbeiten des Sensorsignals basierend auf einer Transformation und/oder einer linearen Hauptkomponentenanalyse und/oder einer linearen Diskriminanzanalyse eingerichtet sein.

So kann das Sensorsignal vorverarbeitet werden, bevor das Zwischensignal ermittelt wird. Beispielsweise kann das Sensorsignal durch die Vorverarbeitung so aufbereitet werden, dass eine Verrechnung mit dem vorgegebenen Referenzsignal zu dem Zwischensignal effizient möglich ist.

Das vorgegebene Referenzsignal kann also anschaulich als das Sensorsignal des Sensors unter vordefinierten Bedingungen verstanden werden. Diese Bedingungen entsprechen den Bedingungen, die zur Ermittlung des Referenzsignals des Referenzsensors verwendet wurden, welcher für das Training verwendet wurde. Durch die Ermittlung des Zwischensignals basierend auf dem Sensorsignal (also auf der vom individuellen Sensor jeweils aufgenommenen Pulsantwort unter den auszuwertenden Bedingungen, also den Bedingungen im realen Einsatz) und dem vorgegebenen Referenzsignal (also beispielsweise dem von dem individuellen Sensor unter den Trainingsbedingungen (beispielsweise Referenzbedingungen) aufgenommenen Sensorsignal) gelingt es, störende sensorindividuelle Merkmale wie Fertigungstoleranzen zu kompensieren, so dass auf ein sensorindividuelles Training eines Maschinenlernverfahrens verzichtet werden kann.

In einer vorteilhaften Ausgestaltung des Sensors kann die Vorverarbeitungseinheit zum Ermitteln des Zwischensignals basierend auf einer Differenz zwischen dem Sensorsignal und dem vorgegebenen Referenzsignal eingerichtet sein.

Durch die Differenzbildung ist eine einfache Ermittlung des Zwischensignals möglich, wobei das Zwischensignal dennoch geeignet ist, bei Verwendung der Auswerteeinheit zuverlässig den Ausgabewert zu erhalten.

Beispielsweise kann die Auswerteeinheit mindestens eine Gaussian Process Regression durchführen und/oder mindestens eine Support-Vector-Maschine und/oder mindestens einen Entscheidungsbaum und/oder mindestens ein künstliches neuronales Netz und/oder mindestens ein lineares Modell aufweisen.

Dabei können die Maschinenlernverfahren zur Verarbeitung des Zwischensignals basierend auf Daten trainiert oder konfiguriert worden sein, die von einem Referenzsensor oder Prototyp des Sensors (also von einem einzigen Sensor vom gleichen Typ wie der Sensor) stammen. Es muss daher nicht für jeden individuellen Sensor (also jeden einzelnen Sensor) trainiert oder konfiguriert werden. Es kann ausreichen, nur das Referenzsignal sensorspezifisch zu ermitteln und für die Auswertung beispielsweise in einem Speicher bereitzustellen.

Das in der Auswerteeinheit eingesetzte Maschinenlernverfahren wurde also vor dem Produktiveinsatz des Sensors einmalig trainiert. Das Maschinenlernverfahren und damit die Auswerteeinheit werden, insbesondere im Produktiveinsatz, dann nicht mehr verändert.

Insbesondere kann der Sensor ein induktiver Näherungssensor sein. Der Sensor kann mindestens eine Spule und Mittel zum Speisen der mindestens einen Spule aufweisen. Der Ausgabewert kann einen Abstand eines Objekts, beispielsweise eines (z.B. metallischen) Targets oder eines zu erfassenden Gegenstands, von dem Sensor repräsentieren.

Es hat sich gezeigt, dass insbesondere induktive Näherungssensoren sensitiv auf Schwankungen beispielsweise in den Sensorabmessungen basierend auf den Fertigungstoleranzen reagieren. Durch die erfindungsgemäße Verwendung eines Zwischensignals können die Auswirkungen dieser Schwankungen zumindest weitgehend eliminiert werden.

Der Abstand kann dabei ein Abstand in einer Längeneinheit (beispielsweise in Metern oder Millimetern sein), oder kann ein Fuzzy-Wert sein (wie "so weit weg, dass nicht erfassbar", "in der näheren Umgebung", "ganz nah oder berührend"), oder ein binärer Wert (beispielsweise "Target in Abstandsmessweite erkannt" und "kein Target in Abstandsmessweite erkannt").

Die Aufgabe der Erfindung wird ferner durch ein Verfahren zum Auswerten eines Sensorsignals mit den folgenden Schritten gelöst:

- Erfassen eines Sensorsignals;
- Ermitteln eines Zwischensignals basierend auf dem Sensorsignal und einem vorgegebenen Referenzsignal; und
- Ermitteln eines Ausgabewerts basierend auf dem Zwischensignal mittels einer gemäß einem Maschinenlernverfahren trainierten Auswerteeinheit.

Die Aufgabe der Erfindung wird ferner durch ein Verfahren zum Trainieren einer Auswerteeinheit (beispielsweise die Auswerteeinheit des erfindungsgemäßen Sensors oder des erfindungsgemäßen Verfahrens zum Auswerten eines Sensorsignals) zum Auswerten eines Sensorsignals mit den folgenden Schritten gelöst:

- Bereitstellen einer Mehrzahl von Trainingssensorsignalen, wobei jedem Trainingssensorsignal ein entsprechender Trainingsausgabewert zugeordnet ist;
- Ermitteln eines dem jeweiligen Trainingssensorsignal zugeordneten Zwischensignals für jedes Trainingssensorsignal basierend auf dem jeweiligen Trainingssensorsignal und einem vorgegebenen Referenzsignal;
- Ermitteln eines dem jeweiligen Trainingssensorsignal zugeordneten Ausgabeeinheitausgabewertes für jedes Trainingssensorsignal basierend auf dem dem jeweiligen Trainingssensorsignal zugeordneten Zwischensignal unter Verwendung der Auswerteeinheit; und
- Trainieren der Auswerteeinheit basierend auf den Ausgabeeinheitausgabewerten und den Trainingsausgabewerten.

Die Trainingssensorsignale und die jeweils entsprechenden Trainingsausgabewerte können dabei vorab dadurch ermittelt werden, dass für einen Sensor (beispielsweise einen Referenzsensor oder Prototyp des Sensors, dessen Sensorsignal später ausgewertet werden soll) Sensorsignale unter vorgegebenen äußeren Umständen gemessen werden, die ein Ermitteln des jeweils idealen Ausgabewertes über ein geeignetes anderes Messinstrument ermöglichen. Es kann also die Messgröße bekannt sein, beispielsweise durch Messung über das geeignete andere Messinstrument. Dem vom Sensor gelieferten Sensorsignal kann dann die bekannte Messgröße zugeordnet werden. Ein idealer Sensor würde also bei Vorliegen einer Situation, die der Messgröße entspricht, eine Pulsantwort liefern, die nach Verwendung in der Auswerteeinheit die Messgröße als Ausgabewert liefert.

Durch das Trainieren der Auswerteeinheit kann sichergestellt sein, dass zumindest für Sensorsignale, die identisch sind zu den Trainingssensorsignalen, die korrekten Ausgabewerte (also die den Trainingssensorsignalen zugeordneten Trainingsausgabewerte) ermittelt werden. Die Auswerteeinheit wird bei gutem Training dann auch für Sensorsignale, die nicht identisch zu den Trainingssensorsignalen sind, gute Ausgabewerte ermitteln.

Vorteilhafterweise weist das Trainieren der Auswerteeinheit ein Bestimmen von in der Auswerteeinheit zur Ermittlung der Ausgabeeinheitausgabewerte verwendeten Parametern auf.

Die Parameter können dabei die Struktur der Ausgabeeinheit und/oder interne Parameter der Ausgabeeinheit definieren. Beispielsweise bei Ausgestaltung der Ausgabeeinheit als neuronales Netz mit vorgegebener Struktur können die Parameter Gewichte innerhalb des neuronalen Netzes sein.

In einer vorteilhaften Ausgestaltung des Verfahrens werden die Parameter mittels eines Optimierungsverfahrens bestimmt. Durch die Verwendung eines Optimierungsverfahrens kann sichergestellt sein, dass die Parameter so ermittelt werden, dass die Auswerteeinheit zumindest für die Trainingssensorsignale die bestmöglichen Ausgabewerte (also Ausgabewerte, die möglichst nah an den Trainingsausgabewerten liegen) ermittelt. Diese Parameter können dann auch gut geeignet sein, um Ausgabewerte basierend auf Sensorsignalen im realen Betrieb, also Ausgabewerte basierend auf Sensorsignalen, die nicht den Trainingssensorsignalen entsprechen, zu ermitteln.

Mit den erfindungsgemäßen Sensoren und Verfahren können beispielsweise Induktivsensoren mit hohen Schaltabständen (beispielsweise mit mindestens vierfachem Schaltabstand, also beispielsweise einem vierfachen Nennabstand nach Norm, beispielsweise 8 mm bei einem M12 Bündig-Sensor) bereitgestellt werden, die zumindest auf Aluminium und Stahl ein F1-Verhalten haben. Zudem kann der hohe Schaltabstand von Induktivsensoren unabhängig von deren Einbautiefe und Einbaumaterial erreicht werden.

Die Auswertung des Sensorsignals (beispielsweise der Pulsantwort) mit Maschinenlernverfahren hat den großen Vorteil, dass damit ein Schaltsignal (in anderen Worten: ein Ausgabewert) erzeugt werden kann, der nahezu unabhängig vom Material des Targets (beispielsweise des Objekts, dessen Abstand ermittelt werden soll) und der Einbausituation ist und sehr hohe Schaltabstände hat.

Die erfindungsgemäße Vorverarbeitung erlaubt es außerdem, dass das Maschinenlernverfahren im Labor nur einmal für einen bestimmten Sensortyp trainiert werden muss (also nur für einen einzigen Referenzsensor) und nicht für jeden Sensor einzeln. Dadurch wird eine Verwendung in der Massenproduktion überhaupt erst sinnvoll möglich.

Mit der Verarbeitung des Sensorsignals (beispielsweise mit der Verarbeitung einer Pulsantwort) unter Verwendung von Maschinenlernverfahren kann mehr Informationen gewonnen kann als unter Verwendung z. B. nur eines Integralwerts, da das Maschinenlernverfahren die Abtastwerte (also die Werte des zeitlichen Verlaufs an mehreren Zeitpunkten, zu denen das Sensorsignal erfasst oder abgetastet wird) beliebig verrechnen und miteinander kombinieren kann.

Ferner ist es durch den erfindungsgemäßen Einsatz der Auswerteeinheit möglich, das Targetmaterial zu erkennen, um z.B. einen materialunabhängigen Schaltpunkt zu generieren (F1-Verhalten). Ebenso ist es auch möglich z.B. Buntmetalle komplett auszublenden, so dass der Sensor nur noch auf ferromagnetische Materialen reagiert.

Ebenfalls ist es durch den erfindungsgemäßen Einsatz der Auswerteeinheit möglich, störende Einflüsse der Umgebung auszublenden und so einen gleichmäßig hohen Schaltabstand für alle Einbausituationen zu erzielen.

Vorteile, Details und bevorzugte Ausgestaltungen, die für den Sensor beschrieben sind, gelten auch für das Verfahren zum Auswerten eines Sensorsignals und das Verfahren zum Trainieren einer Auswerteeinheit zum Auswerten eines Sensorsignals, und umgekehrt.

Weitere vorteilhafte Ausgestaltungen der erfindungsgemäßen Verfahren ergeben sich aus den Unteransprüchen, der Zeichnung und der Beschreibung.

Die Erfindung wird nachfolgend anhand von Ausführungsbeispielen mit Bezug auf die Zeichnung beschrieben. Es zeigen in schematischen Darstellungen:

Fig. 1 ein Blockschaltbild eines Sensors gemäß einer Ausführungsform;

Fig. 2A eine Illustration der Ermittlung eines Zwischensignals gemäß einer Ausführungsform;

Fig. 2B eine Illustration der Reduzierung von toleranzbedingten Abweichungen des Zwischensignals gemäß einer Ausführungsform;

Fig. 3 ein Flussdiagramm, das ein Verfahren zum Auswerten eines Sensorsignals gemäß einer Ausführungsform veranschaulicht; und

Fig. 4 ein Flussdiagramm, das ein Verfahren zum Trainieren einer Auswerteeinheit zum Auswerten eines Sensorsignals gemäß einer Ausführungsform veranschaulicht.

Nachfolgend werden die erfindungsgemäßen Sensoren und Verfahren exemplarisch anhand eines Ausführungsbeispiels erläutert.

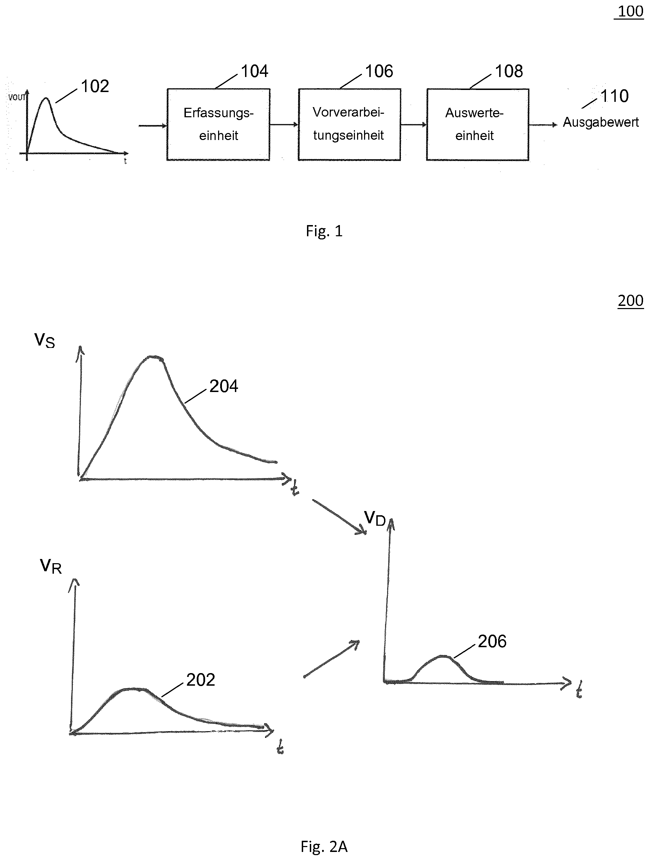

Fig. 1 zeigt ein Blockschaltbild 100 eines Sensors (beispielsweise eines Abstandsensors) gemäß einer Ausführungsform. Ein Sensorsignal 102 wird in einer Erfassungseinheit 104 erfasst. Die Erfassungseinheit 104 kann als Digitalisierungseinheit zum Digitalisieren des Sensorsignals 102 eingerichtet sein. Das digitalisierte Sensorsignal wird in einer Vorverarbeitungseinheit 106 vorverarbeitet. Beispielsweise kann in der Vorverarbeitungseinheit 106 ein Zwischensignal basierend auf dem digitalisierten Sensorsignal und einem vorgegebenen Referenzsignal ermittelt werden. Das Zwischensignal kann in einer Auswerteeinheit 108, die beispielsweise als Machine-Learning-Einheit (also als Einheit für maschinelles Lernen) ausgestaltet sein kann, verarbeitet werden, um einen Ausgabewert 110 (im Fall eines Abstandsensors beispielsweise einen Targetabstand) zu ermitteln.

Der Sensor kann ein induktiver Näherungssensor mit mindestens einer Spule und Mitteln zum Speisen der Spule mit mindestens einem Sendestromimpuls (oder Sendestrompuls) sein. Der Sendestrompuls kann beispielsweise zumindest näherungsweise eine Rechteckform haben, aber auch eine beliebige andere Form. Die Erfassungseinheit 104 kann eingerichtet sein zum kompletten oder teilweisen Digitalisieren des induzierten Spannungspulses, der sich durch den Strompuls an der Spule ergibt. Die Erfassungseinheit 104 digitalisiert den Spannungspuls ab dem Anlegen des Strompulses bis zum vollständigen oder teilweisen (beispielsweise auf einen vorgegebenen Pegel) Abklingen des Spannungspulses. Der Spannungspuls kann auch als Pulsantwort bezeichnet werden. Die Auswerteeinheit 108 kann mit Methoden des maschinellen Lernens trainiert worden sein. Durch den Einsatz der Vorverarbeitungseinheit 106 können durch einen oder mehrere Vorverarbeitungsschritte sensorindividuelle Merkmale zumindest weitgehend eliminiert werden sowie die Ergebnisse der Auswerteeinheit 108 verbessert werden.

Die einzelnen Abtastwerte (also die digitalisierten Sensorsignale zu den einzelnen Zeitschritten) können in der Vorverarbeitungseinheit 106 beispielsweise vorverarbeitet werden durch: Verrechnung mit einem abgespeicherten Referenzsignal und/ oder Skalierung und/oder eine Transformation (z.B. diskrete Kosinustransformation; DCT) und/oder eine Hauptkomponentenanalyse (englisch: Principal Component Analysis; PCA) und/oder eine lineare Diskriminanzanalyse (LDA).

Die vorverarbeiteten Abtastwerte können in der Auswerteeinheit 108 beispielsweise ausgewertet werden durch eine Gaussian Process Regression und/oder ein Ensemble von Gaussian Process Regression und/oder eine Support-Vektor-Maschine und/oder ein Ensemble von Support-Vektor-Maschinen und/oder einen Entscheidungsbaum und/oder ein Ensemble von Entscheidungsbäumen und/oder ein künstliches neuronales Netz und/oder ein Ensemble von künstlichen neuronalen Netze und/oder ein lineares Modell und/oder ein Ensemble von linearen Modellen und/oder ein Ensemble aus den obigen Methoden.

Eine vorteilhafte Ausführungsform der Vorverarbeitung ist die Verrechnung der aufgenommenen Pulsantwort mit mindestens einer abgespeicherten Pulsantwort der aus der Messung von diesem Sensor in einer definierten Umgebung (z.B. definierter Einbau, Einbaumaterial, Targetabstand, Targetmaterial) stammt. Die definierte Umgebung kann identisch oder ähnlich sein zu der Umgebung, die zur Ermittlung der abgespeicherten Pulsantwort (Referenzsignal) des Referenzsensors verwendet wurde, der für das Training benutzt wurde. Mehr als eine abgespeicherte Pulsantwort kann z. B. Verwendung finden, wenn zwei unterschiedliche Referenzpulse bei unterschiedlichen Target-Materialen bestimmt und gespeichert wurden, und dann die Ermittlung des Ausgabewerts basierend auf den zwei unterschiedlichen Referenzpulsen erfolgt. Dabei kann beispielsweise einer Differenzbildung zwischen der erfassten oder aufgenommenen (aktuellen) Pulsantwort und der abgespeicherten Pulsantwort erfolgen und ein Maschinenlernverfahren auf diese Differenz angewendet werden. Damit können große Teile des Einflusses von Fertigungstoleranzen eliminiert werden.

Ferner werden durch die erfindungsgemäße Vorverarbeitung dem Maschinenlernverfahren nicht alle möglichen Informationen zur Verfügung gestellt, sondern im Wesentlichen nur die für die Entscheidung relevanten und signifikanten Informationen. Dadurch wird ein Overfitting verhindert und das Maschinenlernverfahren generalisiert besser, wenn es unbekannte oder z.B. durch Fertigungstoleranzen leicht veränderte Daten als Eingabe bekommt.

Ein ergänzender vorteilhafter Vorverarbeitungsschritt kann die Skalierung der Messwerte oder eine Transformation oder eine Hauptkomponentenanalyse sein.

Beispielsweise kann in der Vorverarbeitungseinheit 106 eine Differenz (als Zwischensignal) aus dem digitalisierten Sensorsignal und einem vorgegebenen Referenzsignal ermittelt werden, und die weitere Bearbeitung kann dann basierend auf dieser Differenz erfolgen.

Fig. 2A zeigt eine Illustration 200 einer Ermittlung des Zwischensignals gemäß einer Ausführungsform. Das Sensorsignal $v_s$ 204 und das vorgegebenes Referenzsignal $v_R$ 202 können so verarbeitet werden, dass ein Differenzsignal 206 ermittelt wird, wobei das Differenzsignal $v_D$ für jeden Zeitschritt t die Differenz des Sensorsignals $v_s$ an diesem Zeitschritt t und des Referenzsignals $v_R$ an diesem Zeitschritt t angibt:

$$v_D(t) = v_S(t) - v_R(t).$$

Der zeitliche Verlauf der Differenz kann mit der Auswerteeinheit 108 und damit mit Methoden des maschinellen Lernens verarbeitet werden.

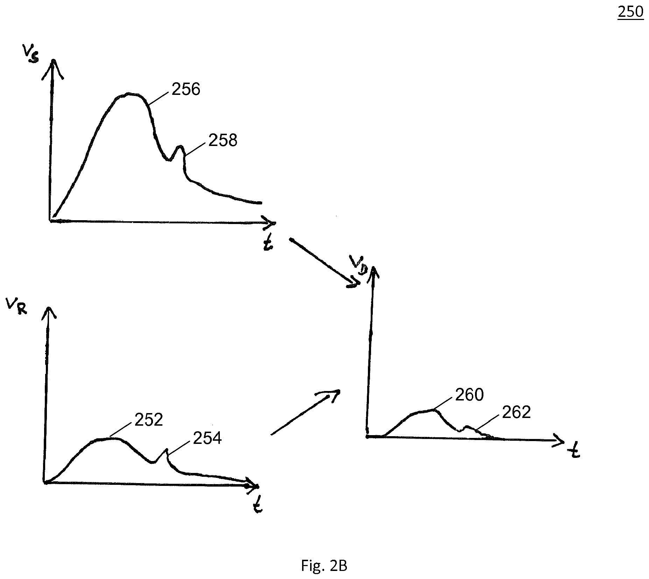

Fig. 2B zeigt eine Illustration 250 der Reduzierung von toleranzbedingten Abweichungen des Zwischensignals gemäß einer Ausführungsform. Ein im tatsächlichen Betrieb aufgenommenes Sensorsignal 256 kann, beispielsweise durch Fertigungstoleranzen bedingt, eine toleranzbedingte Abweichung 258 von einem idealen Sensorsignal aufweisen. Das Referenzsignal 252, das zur Ermittlung des Differenzsignals 260 verwendet wird, kann ein unter vorgegebenen Bedingungen von dem Sensor erzeugtes Signal sein, d.h. das Referenzsignal 256 zeigt ebenso wie das im tatsächlichen Betrieb aufgenommene Sensorsignal 256 eine Abweichung, beispielsweise eine toleranzbedingte Abweichung 254. Die toleranzbedingte Abweichung 254 des Referenzsignals 256 muss nicht identisch sein zur toleranzbedingten Abweichung 258 des im tatsächlichen Betrieb aufgenommenen Sensorsignals 256, jedoch wird es zumindest ähnlich sein. Dadurch kann im Differenzsignal 260 die Auswirkung der toleranzbedingten Abweichung 258 reduziert werden, so dass eine Abweichungsdifferenz 262 deutlich kleiner ist als die toleranzbedingte Abweichung 258.

Es wird verstanden werden, dass, obwohl in Fig. 2B eine Spitze im abklingenden Signal als die toleranzbedingte Abweichung illustriert ist, die toleranzbedingte Abweichung auch andere Auswirkungen haben kann, beispielsweise eine Änderung des Maximalwertes des Sensorsignals 256 oder eine Änderung der Abklingdauer des Sensorsignals 256. In jedem Fall jedoch ist die toleranzbedingte Abweichung 254 des Referenzsignals 256 zumindest ähnlich zur toleranzbedingten Abweichung 258 des im tatsächlichen Betrieb aufgenommenen Sensorsignals 256, so dass eine Abweichung (in anderen Worten: Abweichungsdifferenz 262) im Differenzsignal 260 deutlich reduziert werden kann. Dies kann ein Training für Maschinenlernverfahren basierend auf dem Differenzsignal 260 erleichtern bzw. die Ergebnisse eines Maschinenlernverfahrens basierend auf dem Differenzsignal 260 verbessern, verglichen mit Maschinenlernverfahren, die direkt das Sensorsignal 256 verwenden.

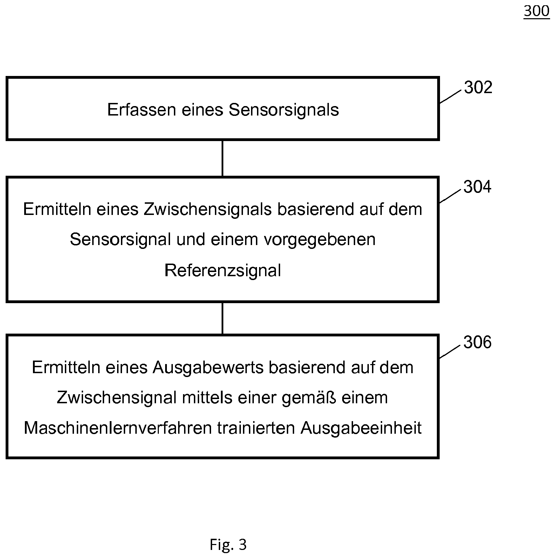

Fig. 3 zeigt ein Flussdiagramm 300, das ein Verfahren zum Auswerten eines Sensorsignals gemäß einer Ausführungsform veranschaulicht. In 302 kann ein Sensorsignal erfasst werden. In 304 kann ein Zwischensignal basierend auf dem Sensorsignal und einem vorgegebenen Referenzsignal ermittelt werden. In 306 kann ein Ausgabewerts basierend auf dem Zwischensignal mittels einer gemäß einem Maschinenlernverfahren trainierten Auswerteeinheit ermittelt werden.

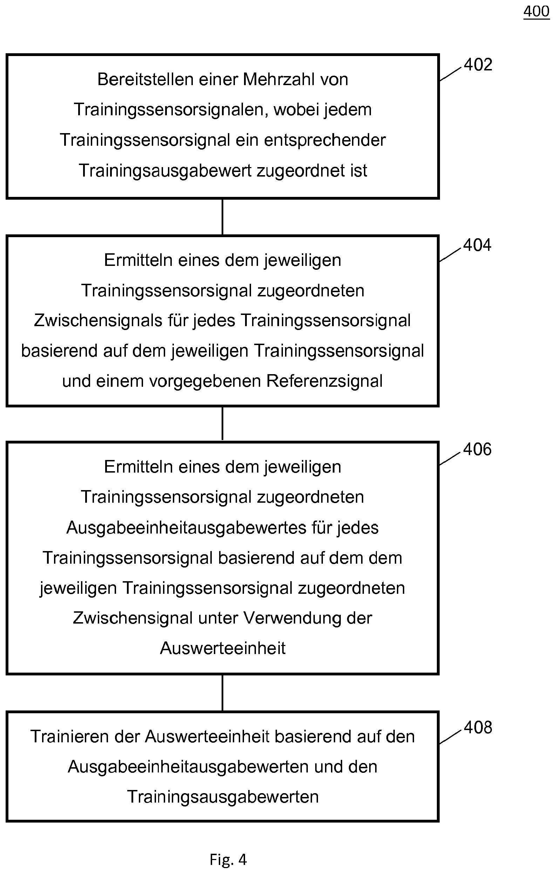

Fig. 4 zeigt ein Flussdiagramm 400, das ein Verfahren zum Trainieren einer Auswerteeinheit zum Auswerten eines Sensorsignals gemäß einer Ausführungsform veranschaulicht. In 402 kann eine Mehrzahl von Trainingssensorsignalen bereitgestellt werden, wobei jedem Trainingssensorsignal ein entsprechender Trainingsausgabewert zugeordnet ist. In 404 kann für jedes Trainingssensorsignal basierend auf dem jeweiligen Trainingssensorsignal und einem vorgegebenen Referenzsignal ein dem jeweiligen Trainingssensorsignal zugeordnetes Zwischensignal ermittelt werden. In 406 kann für jedes Trainingssensorsignal unter Verwendung der Auswerteeinheit basierend auf dem dem jeweiligen Trainingssensorsignal zugeordneten Zwischensignal ein dem jeweiligen Trainingssensorsignal zugeordneter Ausgabeeinheitausgabewert ermittelt werden. In 408 kann die Auswerteeinheit basierend auf den Ausgabeeinheitausgabewerten und den Trainingsausgabewerten trainiert werden.

Das im Verfahren zum Auswerten des Sensorsignals verwendete vorgegebene Referenzsignal kann sensorindividuell unter ähnlichen oder identischen Bedingungen aufgenommen worden sein wie das vorgegebene Referenzsignal des Referenzsensors, welches im Verfahren zum Trainieren einer Auswerteeinheit zum Auswerten eines Sensorsignals gemäß einer Ausführungsform verwendet wird.

**Bezugszeichenliste**

| | |
|---|---|
| 100 | Blockschaltbild |
| 102 | Sensorsignal |
| 104 | Erfassungseinheit |
| 106 | Vorverarbeitungseinheit |
| 108 | Auswerteeinheit |
| 110 | Ausgabewert |

| | |
|---|---|
| 200 | Illustration einer Ermittlung des Zwischensignals |
| 202 | vorgegebenes Referenzsignal |
| 204 | Sensorsignal |
| 206 | Differenzsignal |

| | |
|---|---|
| 250 | Illustration einer Reduzierung von toleranzbedingten Abweichungen |
| 252 | vorgegebenes Referenzsignal |
| 254 | toleranzbedingte Abweichung |
| 256 | Sensorsignal |
| 258 | toleranzbedingte Abweichung |
| 260 | Differenzsignal |
| 262 | Abweichungsdifferenz |

| | |
|---|---|
| 300 | Flussdiagramm, das ein Verfahren zum Auswerten eines Sensorsignals gemäß einer Ausführungsform veranschaulicht |
| 302 | Verfahrensschritt |
| 304 | Verfahrensschritt |
| 306 | Verfahrensschritt |
| 400 | Flussdiagramm, das ein Verfahren zum Trainieren einer Auswerteeinheit zum Auswerten eines Sensorsignals gemäß einer Ausführungsform veranschaulicht |
| 402 | Verfahrensschritt |
| 404 | Verfahrensschritt |

| | |
|---|---|
| 406 | Verfahrensschritt |
| 408 | Verfahrensschritt |

**Patentansprüche**

1. Sensor zum Ermitteln eines Ausgabewerts, insbesondere induktiver Näherungssensor, wobei der Sensor aufweist:

   - eine Erfassungseinheit (104), eingerichtet zum Erfassen eines Sensorsignals (102, 204);
   - eine Vorverarbeitungseinheit (106), eingerichtet zum Ermitteln eines Zwischensignals (206) basierend auf dem Sensorsignal (102, 204) und einem vorgegebenen Referenzsignal (202); und
   - eine gemäß einem Maschinenlernverfahren trainierte Auswerteeinheit (108), eingerichtet zum Ermitteln des Ausgabewerts (110) basierend auf dem Zwischensignal (206);

   wobei das vorgegebene Referenzsignal (202) ein Sensorsignal des Sensors und/ oder ein Sensorsignal eines Referenzsensors ist.

2. Sensor nach Anspruch 1, wobei die Erfassungseinheit (104) eingerichtet ist zum Digitalisieren des Sensorsignals (102, 204).

3. Sensor nach einem der Ansprüche 1 oder 2, wobei die Vorverarbeitungseinheit (106) eingerichtet ist zum Vorverarbeiten des Sensorsignals (102, 204) basierend auf einer diskreten Kosinustransformation oder einer linearen Hauptkomponentenanalyse oder einer linearen Diskriminanzanalyse.

4. Sensor nach einem der Ansprüche 1 bis 3, wobei für jeden Sensor ein sensorspezifischer Referenzpuls als Referenzsignal (202) aufgenommen und abgespeichert ist.

5. Sensor nach einem der Ansprüche 1 bis 4, wobei die Vorverarbeitungseinheit (106) eingerichtet ist zum Ermitteln mindestens eines Zwischensignals (206) basierend auf dem Sensorsignal (102, 204) und mindestens einem vorgegebenen Referenzsignal (202), das aus einer Mehrzahl von Referenzsignalen (202) ausgewählt wird.

6. Sensor nach einem der Ansprüche 1 bis 5, wobei die Vorverarbeitungseinheit (106) eingerichtet ist zum Ermitteln des Zwischensignals (206) basierend auf einer Differenz zwischen dem Sensorsignal (102, 204) und dem vorgegebenen Referenzsignal (202).

7. Sensor nach einem der Ansprüche 1 bis 6, wobei die Auswerteeinheit (108) mindestens eine Gaussian Process Regression durchführt oder mindestens eine Support-Vector-Maschine und/oder mindestens einen Entscheidungsbaum oder mindestens ein künstliches neuronales Netz und/oder mindestens ein lineares Modell aufweist.

**8.** Sensor nach einem der Ansprüche 1 bis 7, ferner aufweisend:

    - mindestens eine Spule; und
    - Mittel zum Speisen der mindestens einen Spule.

**9.** Sensor nach einem der Ansprüche 1 bis 8, wobei der Ausgabewert (110) einen Abstand eines Objekts von dem Sensor repräsentiert.

**10.** Verfahren zum Auswerten eines Sensorsignals (102, 204), insbesondere Verfahren zum Auswerten eines Sensorsignals (102, 204) eines induktiven Näherungssensors, das Verfahren aufweisend:

    - Erfassen (302) eines Sensorsignals (102, 204);
    - Ermitteln (304) eines Zwischensignals (206) basierend auf dem Sensorsignal (102, 204) und einem vorgegebenen Referenzsignal (202); und
    - Ermitteln (306) eines Ausgabewerts (110) basierend auf dem Zwischensignal (206) mittels einer gemäß einem Maschinenlernverfahren trainierten Auswerteeinheit (108);

wobei das vorgegebene Referenzsignal (202) ein Sensorsignal des Sensors und/ oder ein Sensorsignal eines Referenzsensors ist.

**11.** Verfahren zum Trainieren eines Auswerteeinheit (108) zum Auswerten eines Sensorsignals (102, 204) des Sensors nach einem der Ansprüche 1 bis 9, wobei die Auswerteeinheit (108) ein künstliches neuronales Netz ist, das Verfahren aufweisend:

    - Bereitstellen (402) einer Mehrzahl von Trainingssensorsignalen, wobei jedem Trainingssensorsignal ein entsprechender Trainingsausgabewert zugeordnet ist;
    - Ermitteln (404) eines dem jeweiligen Trainingssensorsignal zugeordneten Zwischensignals für jedes Trainingssensorsignal basierend auf dem jeweiligen Trainingssensorsignal und einem vorgegebenen Referenzsignal (202);
    - Ermitteln (406) eines dem jeweiligen Trainingssensorsignal zugeordneten Ausgabeeinheitausgabewertes für jedes Trainingssensorsignal basierend auf dem dem jeweiligen Trainingssensorsignal zugeordneten Zwischensignal unter Verwendung der Auswerteeinheit (108); und
    - Trainieren (408) der Auswerteeinheit (108) basierend auf den Ausgabeeinheitausgabewerten und den Trainingsausgabewerten;

wobei das vorgegebene Referenzsignal (202) ein Sensorsignal des Sensors und/ oder ein Sensorsignal eines Referenzsensors ist.

**12.** Verfahren gemäß Anspruch 11, wobei das Trainieren (408) der Auswerteeinheit (108) ein Bestimmen von in der Auswerteeinheit (108) zur Ermittlung der Ausgabeeinheitausgabewerte verwendeten Parametern umfasst.

**13.** Verfahren gemäß Anspruch 12, wobei die Parameter mittels eines Optimierungsverfahrens bestimmt werden.

## Claims

**1.** A sensor for determining an output value, in particular an inductive proximity sensor, wherein the sensor has:

    - a detection unit (104) configured to detect a sensor signal (102, 204);
    - a preprocessing unit (106) configured to determine an intermediate signal (206) on the basis of the sensor signal (102, 204) and of a predefined reference signal (202); and
    - an evaluation unit (108) which is trained in accordance with a machine learning method and which is configured to determine the output value (110) on the basis of the intermediate signal (206),

wherein the predefined reference signal (202) is a sensor signal of the sensor and/or a sensor signal of a reference sensor.

**2.** A sensor in accordance with claim 1, wherein the detection unit (104) is configured to digitize the sensor signal (102, 204).

**3.** A sensor in accordance with one of the claims 1 or 2, wherein the preprocessing unit (106) is configured to preprocess the sensor signal (102, 204) on the basis of a discrete cosine transformation or a linear principal component analysis or a linear discriminant analysis.

**4.** A sensor in accordance with any one of the claims 1 to 3, wherein a sensor-specific reference pulse is recorded and stored as a reference signal (202) for each sensor.

**5.** A sensor in accordance with any one of the claims 1 to 4,
wherein the preprocessing unit (106) is configured to determine at least one intermediate signal (206) on the basis of the sensor signal (102, 204) and of at least one predefined reference signal (202) which is selected from a plurality of reference signals (202).

6. A sensor in accordance with any one of the claims 1 to 5,
wherein the preprocessing unit (106) is configured to determine the intermediate signal (206) on the basis of a difference between the sensor signal (102, 204) and the predefined reference signal (202).

7. A sensor in accordance with any one of the claims 1 to 6,
wherein the evaluation unit (108) performs at least one Gaussian process regression or has at least one support vector machine and/or at least one decision tree and/or at least one artificial neural network and/or at least one linear model.

8. A sensor in accordance with any one of the claims 1 to 7, further having:

   - at least one coil; and
   - means for feeding the at least one coil.

9. A sensor in accordance with any one of the claims 1 to 8,
wherein the output value (110) represents a distance of an object from the sensor.

10. A method for evaluating a sensor signal (102, 204), in particular a method for evaluating a sensor signal (102, 204) of an inductive proximity sensor, the method comprising:

   - detecting (302) a sensor signal (102, 204);
   - determining (304) an intermediate signal (206) on the basis of the sensor signal (102, 204) and of a predefined reference signal (202); and
   - determining (306) an output value (110) on the basis of the intermediate signal (206) by means of an evaluation unit (108) trained in accordance with a machine learning method,

   wherein the predefined reference signal (202) is a sensor signal of the sensor and/or a sensor signal of a reference sensor.

11. A method for training an evaluation unit (108) to evaluate a sensor signal (102, 204) of the sensor in accordance with any one of the claims 1 to 9, wherein the evaluation unit (108) is an artificial neural network, the method comprising:

   - providing (402) a plurality of training sensor signals, wherein a corresponding training output value is associated with each training sensor signal;
   - determining (404) an intermediate signal for each training sensor signal, said intermediate signal being associated with the respective training sensor signal, on the basis of the respective training sensor signal and of a predefined reference signal (202);
   - determining (406) an output unit output value for each training sensor signal, said output unit output value being associated with the respective training sensor signal, on the basis of the intermediate signal associated with the respective training sensor signal using the evaluation unit (108); and
   - training (408) the evaluation unit (108) on the basis of the output unit output values and the training output values,

   wherein the predefined reference signal (202) is a sensor signal of the sensor and/or a sensor signal of a reference sensor.

12. A method in accordance with claim 11,
wherein the training (408) of the evaluation unit (108) comprises determining parameters used in the evaluation unit (108) to determine the output unit output values.

13. A method in accordance with claim 12,
wherein the parameters are determined by means of an optimization method.

## Revendications

1. Capteur pour déterminer une valeur de sortie, en particulier capteur de proximité inductif, le capteur comprenant :

   - une unité de détection (104) conçue pour détecter un signal de capteur (102, 204) ;
   - une unité de prétraitement (106) conçue pour déterminer un signal intermédiaire (206) en se basant sur le signal de capteur (102, 204) et sur un signal de référence (202) prédéfini ; et
   - une unité d'évaluation (108) entraînée selon un procédé d'apprentissage machine, conçue pour déterminer la valeur de sortie (110) en se basant sur le signal intermédiaire (206) ;

   le signal de référence (202) prédéfini étant un signal de capteur dudit capteur et/ou un signal de capteur d'un capteur de référence.

2. Capteur selon la revendication 1,
dans lequel l'unité de détection (104) est conçue pour numériser le signal de capteur (102, 204).

3. Capteur selon l'une des revendications 1 ou 2, dans lequel l'unité de prétraitement (106) est conçue pour prétraiter le signal de capteur (102, 204) en se basant sur une transformée en cosinus discrète ou sur une analyse linéaire en composantes principales ou sur une analyse discriminante linéaire.

4. Capteur selon l'une des revendications 1 à 3, dans lequel, pour chaque capteur, une impulsion de référence spécifique au capteur est enregistrée et mémorisée en tant que signal de référence (202).

5. Capteur selon l'une des revendications 1 à 4, dans lequel l'unité de prétraitement (106) est conçue pour déterminer au moins un signal intermédiaire (206) en se basant sur le signal de capteur (102, 204) et sur au moins un signal de référence (202) prédéfini sélectionné parmi une pluralité de signaux de référence (202).

6. Capteur selon l'une des revendications 1 à 5, dans lequel l'unité de prétraitement (106) est conçue pour déterminer le signal intermédiaire (206) en se basant sur une différence entre le signal de capteur (102, 204) et le signal de référence (202) prédéfini.

7. Capteur selon l'une des revendications 1 à 6, dans lequel l'unité d'évaluation (108) effectue au moins une régression par processus gaussien ou comporte au moins une machine à vecteurs de support et/ou au moins un arbre de décision et/ou au moins un réseau neuronal artificiel et/ou au moins un modèle linéaire.

8. Capteur selon l'une des revendications 1 à 7, comprenant en outre :

   - au moins une bobine ; et
   - des moyens pour alimenter ladite au moins une bobine.

9. Capteur selon l'une des revendications 1 à 8, dans lequel la valeur de sortie (110) représente une distance d'un objet par rapport au capteur.

10. Procédé d'évaluation d'un signal de capteur (102, 204), en particulier procédé d'évaluation d'un signal de capteur (102, 204) d'un capteur de proximité inductif, le procédé consistant à :

    - détecter (302) un signal de capteur (102, 204) ;
    - déterminer (304) un signal intermédiaire (206) en se basant sur le signal de capteur (102, 204) et sur un signal de référence (202) prédéfini ; et
    - déterminer (306) une valeur de sortie (110) en se basant sur le signal intermédiaire (206) au moyen d'une unité d'évaluation (108) entraînée selon un procédé d'apprentissage machine ;

le signal de référence (202) prédéfini étant un signal de capteur dudit capteur et/ou un signal de capteur d'un capteur de référence.

11. Procédé d'entraînement d'une unité d'évaluation (108) pour évaluer un signal de capteur (102, 204) dudit capteur selon l'une des revendications 1 à 9, l'unité d'évaluation (108) étant un réseau neuronal artificiel, le procédé consistant à :

    - fournir (402) une pluralité de signaux de capteur d'entraînement, une valeur de sortie d'entraînement correspondante étant associée à chaque signal de capteur d'entraînement ;
    - déterminer (404) un signal intermédiaire associé au signal de capteur d'entraînement respectif pour chaque signal de capteur d'entraînement en se basant sur le signal de capteur d'entraînement respectif et sur un signal de référence (202) prédéfini ;
    - déterminer (406) une valeur de sortie d'unité de sortie associée au signal de capteur d'entraînement respectif pour chaque signal de capteur d'entraînement en se basant sur le signal intermédiaire associé au signal de capteur d'entraînement respectif, en utilisant l'unité d'évaluation (108) ; et
    - entraîner (408) l'unité d'évaluation (108) en se basant sur les valeurs de sortie d'unité de sortie et sur les valeurs de sortie d'entraînement ;

le signal de référence (202) prédéfini étant un signal de capteur dudit capteur et/ou un signal de capteur d'un capteur de référence.

12. Procédé selon la revendication 11, dans lequel l'entraînement (408) de l'unité d'évaluation (108) comprend la détermination de paramètres utilisés dans l'unité d'évaluation (108) pour déterminer les valeurs de sortie d'unité de sortie.

13. Procédé selon la revendication 12, dans lequel les paramètres sont déterminés au moyen d'un procédé d'optimisation.

100

Fig. 1

200

Fig. 2A

250

Fig. 2B

300

```
                                                    ╱302
┌─────────────────────────────────────────┐
│                                         │
│        Erfassen eines Sensorsignals     │
│                                         │
└─────────────────────────────────────────┘
                    │
                                                    ╱304
┌─────────────────────────────────────────┐
│                                         │
│  Ermitteln eines Zwischensignals basierend auf dem │
│     Sensorsignal und einem vorgegebenen │
│               Referenzsignal            │
│                                         │
└─────────────────────────────────────────┘
                    │
                                                    ╱306
┌─────────────────────────────────────────┐
│                                         │
│   Ermitteln eines Ausgabewerts basierend auf dem │
│     Zwischensignal mittels einer gemäß einem │
│  Maschinenlernverfahren trainierten Ausgabeeinheit │
│                                         │
└─────────────────────────────────────────┘
```

Fig. 3

400

Bereitstellen einer Mehrzahl von
Trainingssensorsignalen, wobei jedem
Trainingssensorsignal ein entsprechender
Trainingsausgabewert zugeordnet ist

402

Ermitteln eines dem jeweiligen
Trainingssensorsignal zugeordneten
Zwischensignals für jedes Trainingssensorsignal
basierend auf dem jeweiligen Trainingssensorsignal
und einem vorgegebenen Referenzsignal

404

Ermitteln eines dem jeweiligen
Trainingssensorsignal zugeordneten
Ausgabeeinheitausgabewertes für jedes
Trainingssensorsignal basierend auf dem dem
jeweiligen Trainingssensorsignal zugeordneten
Zwischensignal unter Verwendung der
Auswerteeinheit

406

Trainieren der Auswerteeinheit basierend auf den
Ausgabeeinheitausgabewerten und den
Trainingsausgabewerten

408

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014146623 A1
- US 5898304 A

- DE 102017220788 A1